# EUROPEAN PATENT SPECIFICATION

(11) **EP 2 930 214 B1**
(45) Date of publication and mention of the grant of the patent: **22.05.2019**
(21) Application number: 15162124.0
(22) Date of filing: 01.04.2015
(51) Int. Cl.: C08L 83/04

(54) **SOLAR CELL ENCAPSULANT SILICONE COMPOSITION AND SOLAR CELL MODULE**
SILIKONZUSAMMENSETZUNG ZUR SOLARZELLENVERKAPSELUNG UND SOLARZELLENMODUL
COMPOSITION DE SILICONE D'ENCAPSULATION DE CELLULES SOLAIRES ET MODULE DE CELLULE SOLAIRE

(30) Priority: 07.04.2014 JP 2014078780
(43) Date of publication of application: 14.10.2015
(73) Proprietor: Shin-Etsu Chemical Co., Ltd., Tokyo (JP)
(72) Inventor: Tsukada, Junichi, Gunma-ken (JP); Furihata, Tomoyoshi, Gunma-ken (JP); Ohwada, Hiroto, Gunma-ken (JP); Ito, Atsuo, Tokyo (JP); Yamakawa, Naoki, Gunma-ken (JP); Yaginuma, Atsushi, Gunma-ken (JP)
(74) Representative: Ter Meer Steinmeister & Partner

(56) References cited:
- EP-A1- 2 600 418
- WO-A1-2013/173074
- US-A1- 2013 203 203

## Description

### TECHNICAL FIELD

This invention relates to a solar cell module comprising a solar cell matrix interposed between rigid or flexible, front and back panels via silicone encapsulant, and a silicone encapsulant composition

### BACKGROUND ART

Increasing attention is now paid to solar cells as the energy resource capable of utilizing sunlight. The photovoltaic component of the solar cell is generally composed of semiconductor, typically silicon. A plurality of solar cells are electrically connected to form a solar cell matrix. The solar cell matrix is interposed between a light-receiving panel, typically of glass plate, and a back surface flexible film, known as backsheet, via a thermoplastic resin, known as encapsulant, and united together by means of a laminator, obtaining an integral structure, known as solar cell module.

The solar cell module is protected from the ambient environment including rain, wind, snow and dust by covering the front surface of solar cells on which sunlight is incident and the back surface with the encapsulant. As the encapsulant, ethylene-vinyl acetate (EVA) copolymers which are thermoplastic resins are often used because of low cost and because they are available in sheet form with ease of handling. The method for manufacturing a solar cell module from a solar cell matrix is generally by placing a laminate of light-receiving surface side glass/EVA sheet/solar cell matrix/EVA sheet/back surface panel (backsheet) in a vacuum laminator, vacuum pumping, and compressing under atmospheric pressure at 130 to 150°C for 15 to 30 minutes.

On use of EVA as the encapsulant, however, it is pointed out that acetic acid gradually generates particularly in a hot humid environment. The generated acetic acid causes corrosion to the electrodes of solar cells, undesirably inviting a lowering of electricity generation ability. Since the solar cell is expected to clear long-term service over 20 years, the problem of degradation with time must be promptly solved from the aspect of insurance.

In addition to the above problem, the EVA also suffers from low UV resistance. Upon long-term outdoor exposure, it discolors and turns yellow or brown, detracting from the esthetic appearance.

It would be desirable to replace the EVA encapsulant by an encapsulant material which does not generate an acid even when kept in a hot humid environment for a long term, and is resistant to discoloration upon long-term UV exposure. One of the encapsulant materials free of the above problems is silicone. Specifically, on use of silicone as the encapsulant, which is devoid of acetic acid generation, electrode corrosion is minimized, and the yellow or brown discoloration problem is solved. For example, Non-Patent Document 1 reports that when a silicone-encapsulated solar cell module was re-evaluated after 29 years of outdoor exposure, it was found highly reliable as demonstrated by a drop of maximum power of merely -0.22%/year.

A variety of encapsulation methods have been studied in order to produce silicone-encapsulated solar cell modules. Patent Document 1 describes that a solar cell matrix is placed on or in a liquid silicone material coated on a substrate using a multi-axis robot, and thereafter the silicone material is cured, thereby achieving encapsulation without air bubble entrapment. Also, Patent Document 2 proposes that a solar cell matrix is placed on a cured or semi-cured silicone material in vacuum using a movable plate, referred to as cell press, thereby achieving encapsulation without air bubble entrapment. Patent Document 3 discloses that a silicone encapsulant, a solar cell matrix, and a liquid silicone encapsulant are placed on a glass substrate, a back surface protective substrate is finally laid thereon to construct a precursory laminate, and the precursory laminate is compressed and bonded in vacuum at room temperature to establish a seal.

For the silicone encapsulants used in coating or potting, the optimum viscosity prior to curing for module fabrication has been fully studied, but not the elastic modulus after curing. Provided that a solar cell module is installed in an outdoor environment, its components undergo repetitive thermal expansion/contraction upon heat generation concomitant with electricity generation of solar cells themselves and seasonal and daily thermal cycling. If the physical strength and bond strength of encapsulant are low, dimensional changes of the components with temperature changes are not suppressed, and thermal fatigue is further increased. Among others, finger electrodes serving as the collector electrode are typically designed to a width of 0.05 to 0.2 mm in order to insure a light-receiving area on the solar cell. Such fine electrode can be broken under the influence of thermal expansion/contraction of adjacent interconnects. If finger electrodes are broken, an area of insufficient current collection appears on the solar cell, resulting in a power loss. It is one of the current issues that a solar cell module having fine finger electrodes designed for high efficiency is made fully durable against thermal loads repeated upon thermal cycling.

### Citation List

Patent Document 1: JP-A 2007-527109 (WO 2005/006451)
Patent Document 2: JP-A 2011-514680 (WO 2009/114189)
Patent Document 3: WO 2009/091068
Non-Patent Document 1: Ito, Owada, Furihata, Kim, Yamakawa, Yaginuma, Imataki, Watanabe, and Sakamoto, Preprints of 9th Symposium of Next Generation Solar Photovoltaic System, 2012, p54

### DISCLOSURE OF INVENTION

An object of the invention is to provide a solar cell encapsulant silicone composition and a solar cell module, which are adapted to substantially prevent finger electrodes on the solar cells from breakage with temperature changes, and thus fully reliable.

The inventors have found that a silicone encapsulant composition according to claim 1 which cures into a product having a storage elastic modulus of 1 to 300 MPa in a temperature range of -40°C to 85°C is effective for preventing finger electrodes on the solar cells from breakage with temperature changes of the solar cell module in an outdoor weathering environment.

In connection with a solar cell module comprising light-receiving surface and back surface panels having rigidity or flexibility, a solar cell matrix comprising a plurality of solar cells interposed between the panels, and a silicone encapsulant layer for encapsulating the solar cell matrix, the invention provides a silicone encapsulant composition for forming the silicone encapsulant layer that has a storage elastic modulus of 1 to 300 MPa in a temperature range of -40° C to 85° C comprising
(A) 100 parts by weight of an organopolysiloxane represented by the average compositional formula (I):

   R¹ₐSiO_{(4-a)/2} (I)

   wherein R¹ is each independently a substituted or unsubstituted monovalent hydrocarbon group, and a is a positive number of 1.95 to 2.05, and having a degree of polymerization of at least 100,
(B) 30 to 90 parts by weight of reinforcing silica having a BET specific surface area of at least 50 m²/g,
(C) an effective amount to cure component (A) of a curing agent, and
(D) 0 to 10 parts by weight of a tackifier.

In a preferred embodiment, at least 0.01 part by weight of component (D) is present per 100 parts by weight of component (A), and component (D) is a compound containing at least one of alkoxy, epoxy and (meth)acrylic groups.

Most often, the silicone encapsulant composition is shaped into a sheet having a thickness of 0.3 to 2.5 mm, preferably by calendering or extrusion molding.

In another aspect, the invention provides a method for manufacturing a solar cell module, comprising the steps of laminating a light-receiving surface panel, the silicone encapsulant composition, a solar cell matrix, the silicone encapsulant composition, and a back surface panel in order, and heating and compressing the laminate in vacuum using a vacuum laminator.

Also contemplated herein is a solar cell module manufactured by the method.

### ADVANTAGEOUS EFFECTS OF INVENTION

The silicone encapsulant composition of the invention is effective for suppressing the thermal expansion/contraction of components in a solar cell module with temperature changes, and thus preventing finger electrodes on the solar cells from being broken by thermal loads. The resulting solar cell module is fully reliable.

### BRIED DESCRIPTION OF DRAWINGS

FIG. 1 is a schematic plan view of a solar cell.
FIG. 2 is a cross-sectional view of a silicone-encapsulated module according to the invention.
FIG. 3 is a diagram showing the storage elastic modulus versus temperature of the materials of Examples 1 to 3 and Comparative Examples 1, 2.

### DESCRIPTION OF PREFERRED EMBODIMENTS

The silicone encapsulant composition of the invention is heat cured into a silicone encapsulant layer having a storage elastic modulus of 1 to 300 MPa, preferably 1 to 100 MPa in a temperature range of -40°C to 85°C. If the storage elastic modulus is less than 1 MPa, the layer fails to suppress the thermal expansion/contraction of interconnects with temperature changes and allows for breakage of finger electrodes on the solar cells. If the storage elastic modulus exceeds 300 MPa, the thermal expansion/contraction of the encapsulant itself applies substantial stress to the solar cells in the surface direction, with a possibility of cracks generating in the solar cells. Also the encapsulant layer with a storage elastic modulus in excess of 300 MPa becomes brittle, difficult to handle, and liable to peel due to a high stress applied to the interface with the glass substrate.

The silicone encapsulant composition capable of meeting the desired storage elastic modulus contains the following components (A), (B) and (C) as essential components, and optionally and preferably component (D):
(A) an organopolysiloxane represented by the average compositional formula (I):

   R¹ₐSiO_{(4-a)/2} (I)

   wherein R¹ is each independently a substituted or unsubstituted monovalent hydrocarbon group, and a is a positive number of 1.95 to 2.05, and having a degree of polymerization of at least 100,
(B) reinforcing silica having a specific surface area of at least 50 m²/g,
(C) a curing agent, and
(D) a tackifier.

Component (A) is an organopolysiloxane represented by the average compositional formula (I) and having a degree of polymerization of at least 100.

R¹ₐSiO_{(4-a)/2} (I)

Herein R¹ is each independently a substituted or unsubstituted monovalent hydrocarbon group, and a is a positive number of 1.95 to 2.05.

In formula (I), R¹ is each independently an optionally substituted monovalent hydrocarbon group, preferably 1 to 12 carbon atoms, more preferably 1 to 8 carbon atoms. Examples include alkyl groups such as methyl, ethyl, propyl, butyl, hexyl, and octyl, cycloalkyl groups such as cyclopentyl and cyclohexyl, alkenyl groups such as vinyl, allyl, and propenyl, cycloalkenyl groups, aryl groups such as phenyl and tolyl, aralkyl groups such as benzyl and 2-phenylethyl, and substituted forms of the foregoing in which some or all hydrogen atoms are substituted by halogen atoms, cyano or other radicals. Of these, methyl, vinyl, phenyl and trifluoropropyl are preferred, with methyl and vinyl being most preferred.

The preferred organopolysiloxane is an organopolysiloxane whose backbone consists of repeating dimethylsiloxane units or an organopolysiloxane whose backbone consists of repeating dimethylsiloxane units and siloxane units having phenyl, vinyl, 3,3,3-trifluoropropyl or the like, such as diphenylsiloxane units, methylphenylsiloxane units, methylvinylsiloxane units, or methyl-3,3,3-trifluoropropylsiloxane units.

More preferably, the organopolysiloxane should have at least two aliphatic unsaturated groups such as alkenyl or cycloalkenyl groups, especially vinyl groups per molecule. Herein the aliphatic unsaturated group desirably accounts for 0.01 to 20 mol%, more desirably 0.02 to 10 mol% of the entire R¹ groups. The aliphatic unsaturated group may be attached to a silicon atom at the end of the molecular chain or a silicon atom midway the molecular chain or both. It is preferred that the aliphatic unsaturated group be attached to at least a silicon atom at the end of the molecular chain. The subscript "a" is a positive number of 1.95 to 2.05, preferably 1.98 to 2.02, and more preferably 1.99 to 2.01.

Preferably the organopolysiloxane as component (A) is capped at the end of the molecular chain with a triorganosiloxy group such as trimethylsiloxy, dimethylphenylsiloxy, dimethylhydroxysiloxy, dimethylvinylsiloxy, methyldivinylsiloxy or trivinylsiloxy. Especially preferred are methylvinylpolysiloxane, methylphenylvinylpolysiloxane, and methyltrifluoropropylvinylpolysiloxane.

The organopolysiloxane defined above may be prepared, for example, by (co)hydrolytic condensation of one or more organohalogenosilanes, or by ring-opening polymerization of a cyclic polysiloxane (siloxane trimer, tetramer or oligomer) in the presence of a basic or acidic catalyst. The product is basically a linear diorganopolysiloxane, while component (A) may be a mixture of two or more organopolysiloxanes having different molecular weight (or degree of polymerization) or molecular structure.

The organopolysiloxane should have a degree of polymerization of at least 100, preferably 100 to 100,000, more preferably 3,000 to 20,000, as measured by gel permeation chromatography (GPC) versus polystyrene standards.

Component (B) is reinforcing silica having a BET specific surface area of at least 50 m²/g, which is added to provide a silicone composition with improved mechanical strength before and after curing. In order for the silicone encapsulant composition to be transparent, the BET specific surface area should be more than 200 m²/g, more preferably at least 250 m²/g. If the surface area is up to 200 m²/g, the cured composition may be less transparent. The upper limit of surface area is typically up to 500 m²/g, though not critical.

Examples of the reinforcing silica (B) include dry silica such as fumed silica and wet silica such as precipitated silica. Also useful is silica which has been surface treated to be hydrophobic with such treating agents as chlorosilane, alkoxysilane or hexamethyldisilazane. Treatment with hexamethyldisilazane is preferred for transparency. Use of fumed silica as the reinforcing silica is preferred for higher transparency. The reinforcing silica may be used alone or in admixture of two or more.

The reinforcing silica as component (B) is commercially available. Examples include surface untreated or surface hydrophobized (i.e., hydrophilic or hydrophobic) fumed silica available under the trade name of Aerosil series products, Aerosil 130, Aerosil 200, Aerosil 300, Aerosil R-812, Aerosil R-972, and Aerosil R-974 (Nippon Aerosil Co., Ltd.), Cabosil MS-5 and MS-7 (Cabot Corp.), and Reolosil QS-102, QS-103 and MT-10 (Tokuyama Corp.), and surface untreated or surface hydrophobized precipitated silica available under the trade name of Tokusil US-F (Tokuyama Corp.), Nipsil-SS and Nipsil-LP (Nippon Silica Co., Ltd.).

The reinforcing silica as component (B) is used in an amount of 30 to 90 parts, preferably 40 to 90 parts, and more preferably 50 to 90 parts by weight per 100 parts by weight of the organopolysiloxane as component (A). Outside the range, less amounts of component (B) are ineffective for reinforcement before and after curing, and the cured silicone composition may be less transparent. An excessive amount of component (B) is difficult to disperse in the silicone encapsulant composition and may interfere with shaping of the composition into sheets.

Component (C) is a curing agent which is not particularly limited as long as it can cure component (A). It may be selected from well-known curing agents for silicone materials, preferably (a) an addition reaction or hydrosilylation reaction curing agent, that is, a combination of an organohydrogenpolysiloxane (crosslinker) with a hydrosilylation catalyst, and (b) an organic peroxide.

The crosslinker in the addition reaction curing agent (a) may be an organohydrogenpolysiloxane containing at least two silicon-bonded hydrogen atoms (i.e., SiH groups) per molecule and represented by the average compositional formula (II).

R²_{b}H_{c}SiO_{(4-a)/2} (II)

Herein R² is a substituted or unsubstituted monovalent hydrocarbon group of 1 to 6 carbon atoms, preferably free of aliphatic unsaturation. Suitable monovalent hydrocarbon groups include alkyl groups such as methyl, ethyl, propyl, butyl, pentyl, and hexyl, cyclohexyl, cyclohexenyl, and phenyl, and substituted forms of the foregoing in which at least one hydrogen atom is substituted by halogen, cyano or the like, for example, substituted alkyl groups such as 3,3,3-trifluoropropyl and cyanomethyl. The subscript b is a positive number of 0.7 to 2.1, c is a positive number of 0.01 to 1.0, and the sum b+c is 0.8 to 3.0, and preferably, b is 0.8 to 2.0, c is 0.2 to 1.0, and b+c is 1.0 to 2.5.

The molecular structure of organohydrogenpolysiloxane may be linear, cyclic, branched or three-dimensional network. Preferred is an organohydrogenpolysiloxane which is liquid at room temperature (25°C), specifically in which the number of silicon atoms per molecule, that is, degree of polymerization is 2 to about 300, especially 4 to about 200. The silicon-bonded hydrogen atom (SiH group) may be positioned at the end or side chain of the molecular chain or both. The organohydrogenpolysiloxane used herein contains at least 2 (specifically 2 to 300), preferably at least 3 (specifically 3 to 200), and more preferably 4 to 150 SiH groups per molecule.

Illustrative examples of the organohydrogenpolysiloxane include 1,1,3,3-tetramethyldisiloxane, 1,3,5,7-tetramethylcyclotetrasiloxane, methylhydrogencyclopolysiloxane, methylhydrogensiloxane-dimethylsiloxane cyclic copolymers, tris(dimethylhydrogensiloxy)methylsilane, tris(dimethylhydrogensiloxy)phenylsilane, both end trimethylsiloxy-blocked methylhydrogenpolysiloxane, both end trimethylsiloxy-blocked dimethylsiloxane/- methylhydrogensiloxane copolymers, both end dimethylhydrogensiloxy-blocked dimethylpolysiloxane, both end dimethylhydrogensiloxy-blocked dimethylsiloxane/- methylhydrogensiloxane copolymers, both end trimethylsiloxy-blocked methylhydrogensiloxane/- diphenylsiloxane copolymers, both end trimethylsiloxy-blocked methylhydrogensiloxane/- diphenylsiloxane/dimethylsiloxane copolymers, cyclic methylhydrogenpolysiloxane, cyclic methylhydrogensiloxane/dimethylsiloxane copolymers, cyclic methylhydrogensiloxane/diphenylsiloxane/- dimethylsiloxane copolymers, copolymers of (CH₃)₂HSiO_{1/2} units and SiO_{4/2} units, and copolymers of (CH₃)₂HSiO_{1/2} units, SiO_{4/2} units and (C₆H₅)SiO_{3/2} units. Also included are the foregoing compounds in which some or all methyl groups are substituted by other alkyl groups such as ethyl or propyl, or aryl groups such as phenyl.

An appropriate amount of the organohydrogenpolysiloxane blended is 0.1 to 30 parts, preferably 0.1 to 10 parts, and more preferably 0.3 to 10 parts by weight per 100 parts by weight of the organopolysiloxane (A). Differently stated, the organohydrogenpolysiloxane is preferably used in such amounts that the molar ratio of silicon-bonded hydrogen atoms (i.e., SiH groups) in the organohydrogenpolysiloxane to silicon-bonded alkenyl groups in the organopolysiloxane (A) may range from 0.5/1 to 5/1, more preferably from 0.8 to 4, and even more preferably from 1 to 3.

The hydrosilylation catalyst used for crosslinking reaction in the addition reaction curing agent (a) may be selected from among well-known ones including platinum catalysts, for example, platinum black, platinic chloride, chloroplatinic acid, reaction products of chloroplatinic acid with monohydric alcohols, complexes of chloroplatinic acid with olefins, and platinum bisacetoacetate, palladium catalysts, and rhodium catalysts. The hydrosilylation catalyst may be used in a catalytic amount. A desirable amount is 1 to 100 ppm of platinum group metal based on the organopolysiloxane (A). With less than 1 ppm, addition reaction may not take place to a full extent, resulting in undercure. More than 100 ppm is uneconomical.

Besides the hydrosilylation (or addition reaction) catalyst, an addition reaction regulator may be added for the purpose of adjusting the curing rate or pot life. For example, ethynylcyclohexanol and tetramethyltetravinylcyclotetrasiloxane are useful.

Examples of the organic peroxide (b) include benzoyl peroxide, 2,4-dichlorobenzoyl peroxide, p-methylbenzoyl peroxide, o-methylbenzoyl peroxide, 2,4-dicumyl peroxide, 2,5-dimethyl-bis(2,5-tert-butylperoxy)hexane, di-tert-butyl peroxide, tert-butyl perbenzoate, and 1,6-hexanediol bis(tert-butylperoxy)carbonate.

An appropriate amount of the organic peroxide (b) added is 0.1 to 15 parts, preferably 0.2 to 10 parts by weight per 100 parts by weight of component (A). With less amounts, addition reaction may not take place to a full extent, resulting in a drop of hardness or a lack of strength. An excessive amount is uneconomical and leaves more decomposed product of the curing agent, which can cause discoloration of sheets.

Component (D) is a tackifier which is added to improve the adhesion of the encapsulant layer to the solar cell matrix or the backsheet having a surface of fluoro-resin. It is preferably a compound containing at least one of alkoxy, epoxy and (meth)acrylic groups. Component (D) is preferably added in an amount of 0 to 10 parts, more preferably 0.01 to 8 parts, and even more preferably 0.2 to 5 parts by weight per 100 parts by weight of component (A). Typical examples of component (D) are shown below.

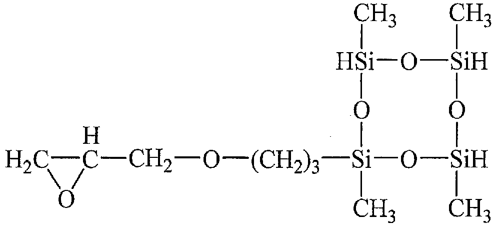

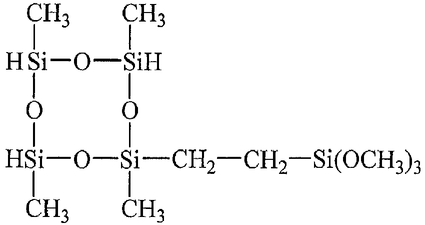

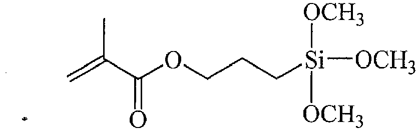

When such a small amount of the tackifier is added to the encapsulant composition, the adhesion of the encapsulant layer to glass widely used as the light-receiving surface panel, ceramics, specifically solar cell surface layer (SiN film), and back electrode (Al) is improved to such an extent that the adhesion may be maintained even after an accelerated deterioration test, for example, after aging under 85°C/85% RH conditions. When the tackifier (D) is added to the addition reaction or hydrosilylation curing agent (a) as component (C), the total amount of organohydrogenpolysiloxane in components (C) and (D) is preferably such that 0.5 to 5 moles, more preferably 0.8 to 4 moles, and even more preferably 1 to 3 moles of silicon-bonded hydrogen atoms (SiH groups) in components (C) and (D) are available per mole of silicon-bonded alkenyl groups in components (A) and (D).

Besides the foregoing components, other additives such as a flame retardant and colorant may be added to the silicone encapsulant composition insofar as the objects of the invention are not impaired.

The silicone encapsulant composition may be prepared by milling predetermined amounts of the foregoing components on a two-roll mill, kneader, Banbury mixer or the like.

The silicone encapsulant composition thus prepared should preferably have a plasticity of 150 to 1,000, more preferably 200 to 800, and even more preferably 250 to 600, prior to curing. A plasticity of less than 150 indicates that an uncured sheet is difficult to maintain its shape and too tacky to handle whereas a plasticity in excess of 1,000 indicates that the composition is crumbly and difficult to shape into sheets.

As previously described, the silicone encapsulant composition is cured into a silicone encapsulant layer having a storage elastic modulus of 1 to 300 MPa in a temperature range of -40°C to 85°C. The hardness of the silicone encapsulant layer is preferably 10 to 85, more preferably 40 to 70 on Durometer Type A hardness scale. The silicone encapsulant layer having a storage elastic modulus and Durometer Type A hardness in the range is obtained by a proper choice of the silicone encapsulant composition formulated as above, preferably so as to increase the crosslinking density by using more reinforcing silica or more aliphatic unsaturated groups.

When the silicone encapsulant composition is shaped into a sheet, any desired shaping technique may be used, with calendering or extrusion molding being preferred. The silicone sheet preferably has a thickness of 0.3 to 2.5 mm, more preferably 0.3 to 1.0 mm. A sheet of less than 0.3 mm may be difficult to bury or seal asperities on the extracting electrode or bus bar electrode without leaving gaps in the subsequent step of heat curing for encapsulation of solar cells. A sheet of more than 2.5 mm is heavy enough to provide the module with an increased weight.

As opposed to the photovoltaic EVA sheet having a dry surface, the silicone sheet in uncured state has surface tack and is deformable. For this reason, the sheeting step is preferably modified such that a laminate film is applied to at least one surface of a sheet, ensuring that when the sheet is taken up as a roll, sheet turns are not bonded. On use, the laminate film is peeled off.

Next, the method for manufacturing a solar cell module according to the invention is described. The solar cell module is generally manufactured through the four steps:
(i) forming a light-receiving surface side panel laminate,
(ii) forming a back surface side backsheet laminate,
(iii) joining the laminates of (i) and (ii), and
(iv) encapsulating solar cells using a vacuum laminator.

The light-receiving surface side panel is a transparent member on which sunlight is incident. It must have improved transparency, weatherability and impact resistance since it is exposed outdoor for a long period of time. Exemplary materials of which the light-receiving surface side panel is made include strengthened colorless glass, acrylic resins, fluoro-resins, and polycarbonate resins. The resin is not limited thereto, while flexible sheet-like panels or sheets of the resin having a thickness of up to 2 mm are suitable. In the case of glass, strengthened colorless glass plates having a thickness of 3 to 5 mm are preferable.

The back surface side is the side of a module opposite to the sunlight-incident side. Although the back surface side may be made of the same material as the light-receiving surface side panel, a resin sheet is typically used for weight reduction purpose. Typically laminated films, known as backsheets, of TPT = PVF/adhesive/PET/adhesive/PVF and TPE = PVF/adhesive/PET/adhesive/EVA are useful, with the TPT laminated films being preferred. Herein, PVF is polyvinyl fluoride and PET is polyethylene terephthalate.

### Step (i)

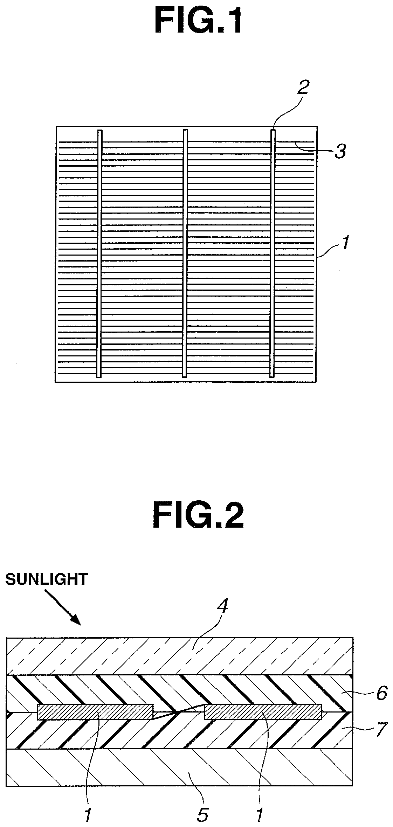

On a light-receiving surface panel, a silicone sheet of the silicone encapsulant composition is rested. A solar cell matrix having solar cells electrically connected is attached to the sheet, with their light-receiving surface situated underneath, yielding a light-receiving surface side panel laminate. The solar cell used herein is a crystalline silicon solar cell using a silicon semiconductor selected from among single crystal silicon and polycrystalline silicon. A plurality of, typically 2 to 60 solar cells are electrically connected with tab wires to construct a solar cell assembly which is the solar cell matrix. A common solar cell is schematically illustrated in FIG. 1 as comprising a solar cell 1, bus bar electrodes 2, and finger electrodes 3.

### Step (ii)

A silicone sheet of the silicone encapsulant composition is attached to a backsheet, yielding a back surface side panel laminate.

### Step (iii)

The light-receiving surface side panel laminate is attached to the back surface side panel laminate such that the back surface of the former is in contact with the silicone sheet of the latter.

### Step (iv)

The precursory laminate of light-receiving surface side panel laminate/back surface side panel laminate joined in step (iii) is placed in a vacuum laminator where the precursory laminate is held in a reduced pressure space for a certain time for deaeration, then heated and compressed under atmospheric pressure to achieve encapsulation of the solar cell matrix. When the precursory laminate of light-receiving surface panel/back surface panel is placed in a reduced pressure space, the reduced pressure is preferably -0.08 to -0.10 MPa through not limited thereto. The heating and compressing conditions may widely vary although the preferred procedure is by vacuum pumping for 3 to 5 minutes and then compressing under atmospheric pressure for 5 to 30 minutes while heating at a temperature of 70 to 150°C, especially 100 to 130°C. During the compressing step, the silicone encapsulant composition (silicone sheet) is crosslinked whereby the light-receiving surface panel, silicone sheet on light-receiving surface panel, solar cell matrix, silicone sheet on back surface panel, and back surface panel are bonded together into an integral body or module. If the heating temperature is lower than 70°C, then the curing rate is so low that cure may not be completed within the molding time. If the heating temperature is higher than 150°C, then the curing rate is so high that cure may begin within the vacuum pumping step, with a possibility of leaving voids between the sheets and the panels. For effective vacuum pumping, preferably the silicone sheets in the uncured state are previously provided with grooves in a zebra or rhombic pattern. The integral body or module resulting from heat compression may be post-cured at 100 to 150°C for 10 minutes to 10 hours.

After step (iv), a frame of aluminum alloy or stainless steel is mounted around the module and fixedly secured thereto by screws or the like, for endowing the module with resistance to shocks. There is obtained a silicone-encapsulated module shown in FIG. 2 as comprising a solar cell 1, light-receiving surface glass panel 4, back surface panel or backsheet 5, light-receiving surface silicone encapsulant layer 6, and back surface silicone encapsulant layer 7.

### EXAMPLE

Examples and Comparative Examples are given below for illustrating the invention although the invention is not limited thereto. In Examples, all parts are by weight. Me stands for methyl, and Vi for vinyl.

### Reference Example

A solar cell matrix was prepared by arranging total 36 single crystal silicon solar cells in a 4/9 column/row matrix and electrically connecting them in series. The solar cell matrix was rested on a strengthened colorless glass plate of 1,494 mm × 674 mm × 3.2 mm thick (Asahi Glass Co., Ltd.), simply referred to as glass plate. This setup was subjected to a thermal cycling test according to IEC 61215. After 200 cycles, the solar cells were inspected for breaks of finger electrodes and cell cracks. The results are shown in Table 1.

A solar cell EL inspector PVX100 (Ites Co., Ltd.) was used for the inspection of conductor breaks and cell cracks before and after the thermal cycling test.

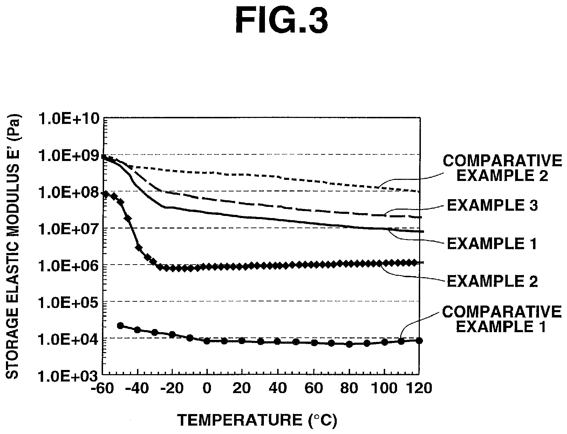

The encapsulation materials used in Examples and Comparative Examples were measured for storage elastic modulus using a viscoelasticity meter DMS7100 (Hitachi High-Tech Science Corp.). The storage elastic modulus of encapsulation materials over a temperature range is shown in the diagram of FIG. 3.

### Example 1

### [Preparation of silicone encapsulant composition]

A silicone compound was prepared by combining 100 parts of organopolysiloxane consisting of 99.825 mol% of dimethylsiloxane units ((CH₃)₂SiO_{2/2}), 0.15 mol% of methylvinylsiloxane units ((CH₂=CH)(CH₃)SiO_{2/2}), and 0.025 mol% of dimethylvinylsiloxy units ((CH₂=CH)(CH₃)₂SiO_{1/2}) and having an average degree of polymerization of ∼6,000, with 70 parts of fumed silica having a BET specific surface area of 300 m²/g (trade name Aerosil 300, Nippon Aerosil Co., Ltd.), 16 parts of hexamethyldisilazane as dispersant, and 4 parts of water, milling the mixture on a kneader, and heat treating at 170°C for 2 hours. Using a two-roll mill, 0.5/2.0 parts of addition crosslinking curing agent C-25A/C-25B (platinum catalyst/organohydrogenpolysiloxane, Shin-Etsu Chemical Co., Ltd.) were added to 100 parts of the compound, which were milled until uniform. The resulting compound was press cured at 130° C and 70 kgf/cm² for 30 minutes into a sheet. Using a viscoelasticity meter DMS7100 (Hitachi High-Tech Science Corp.), the storage elastic modulus of the sheet was measured, with the results being shown by the curve of Example 1 in the diagram of FIG. 3. The cured product or sheet of Example 1 had a Durometer Type A hardness of 55.

### [Manufacture of solar cell module]

### (1) Formation of silicone encapsulant sheet

The silicone encapsulant composition prepared above was sheeted through two rolls into a sheet of 0.7 mm thick. Both the surfaces of the silicone sheet were embossed by sandwiching the silicone sheet between diamond embossing films (Emboss film NEF type, thickness 0.15 mm, Ishijima Chemical Industries, Ltd.) and forcing a rubber roll to press the embossing films against the sheet surfaces. Two silicone sheets having both surfaces embossed were furnished.

### (2) Assembly of light-receiving surface laminate

One embossing film was peeled from the first embossed silicone sheet, which was attached to a glass plate.

### (3) Assembly of back surface laminate

Like the light-receiving surface laminate (2), one embossing film was peeled from the second embossed silicone sheet, which was attached to a TPT sheet of 336 µm thick (MA Packaging Co., Ltd.).

### (4) Assembly of light-receiving surface laminate/back surface laminate

The other embossing film was peeled from the first silicone sheet on the glass plate. A solar cell matrix (obtained by arranging total 36 single crystal silicon solar cells in a 4/9 column/row matrix and connecting them in series), with its light-receiving surface faced underneath, was rested on the bare first silicone sheet. The other embossing film was peeled from the second silicone sheet on the TPT sheet, after which the second silicone sheet with its bare surface faced underneath was rested on the solar cell matrix. There was obtained a precursory laminate of light-receiving surface glass/silicone encapsulant/solar cell matrix/silicone encapsulant/back surface TPT sheet.

### (5) Lamination

The precursory laminate of light-receiving surface laminate/back surface laminate resulting from (4) was placed in a vacuum laminator where vacuum pumping for 5 minutes was followed by compression under atmospheric pressure for 30 minutes while heating at 130°C. A solar cell module was completed.

### [Thermal cycling test]

The solar cell module thus fabricated was subjected to the thermal cycling test. After 200 cycles, the module was inspected for breaks of finger electrodes and cell cracks, using a solar cell EL inspector PVX100 (Ites Co., Ltd.). Also, the module was visually observed for separation at the glass/encapsulant interface. For all test items, no failures were detected. The results are shown in Table 1.

### Example 2

A silicone mixture was prepared by combining 80 parts of organopolysiloxane consisting of 99.5 mol% of dimethylsiloxane units ((CH₃)₂SiO_{2/2}) and 0.5 mol% of dimethylvinylsiloxy units ((CH₂=CH)(CH₃)₂SiO_{1/2}) and having an average degree of polymerization of ∼400, with 20 parts of a silicone resin composed of SiO_{4/2} units, Me₃SiO_{1/2} units, and ViMe₂SiO_{1/2} units in a molar ratio of (Me₃SiO_{1/2}+ViMe₂SiO_{1/2})/SiO_{4/2} of 0.8, and having a vinyl content of 0.085 mol/100 g, 0.3 part of a platinum catalyst in the form of chloroplatinic acid with tetramethylvinyldisiloxane ligand (Pt 1.0 wt%), and 10 parts of organohydrogenpolysiloxane. The mixture was cured at 120° C and 70 kgf/cm² for 30 minutes. As in Example 1, the storage elastic modulus of the cured product was measured, with the results being shown by the curve of Example 2 in FIG. 3. The cured product of Example 2 had a Durometer Type A hardness of 22.

As in Example 1, a solar cell module was fabricated using this silicone encapsulant composition. The results of the module after 200 cycles of the thermal cycling test are shown in Table 1.

### Example 3

A silicone compound was prepared by combining 100 parts of organopolysiloxane consisting of 99.475 mol% of dimethylsiloxane units ((CH₃)₂SiO_{2/2}), 0.475 mol% of methylvinylsiloxane units ((CH₂=CH)(CH₃)SiO_{2/2}), and 0.025 mol% of dimethylvinylsiloxy units ((CH₂=CH)(CH₃)₂SiO_{1/2}) and having an average degree of polymerization of ∼6,000, with 70 parts of fumed silica having a BET specific surface area of 300 m²/g (trade name Aerosil 300, Nippon Aerosil Co., Ltd.), 0.5 part of vinyltrimethoxysilane as dispersant, 10 parts of organopolysiloxane capped with a dimethylvinylsiloxy group at one end and a silanol group at one end and having an average degree of polymerization of ∼20, and 10 parts of organopolysiloxane capped with a silanol group at both ends and having an average degree of polymerization of ∼20, milling the mixture on a kneader, and heat treating at 170°C for 2 hours. Using a two-roll mill, 0.5/3.0 parts of addition crosslinking curing agent C-25A/X-93-1183 (platinum catalyst/organohydrogenpolysiloxane, Shin-Etsu Chemical Co., Ltd.) were added to 100 parts of the compound, which were milled until uniform. As in Example 1, the storage elastic modulus was measured, with the results being shown by the curve of Example 3 in FIG. 3. The cured product of Example 3 had a Durometer Type A hardness of 89.

As in Example 1, a solar cell module was fabricated using this silicone encapsulant composition. The results of the module after 200 cycles of the thermal cycling test are shown in Table 1.

### Comparative Example 1

As a silicone gel composition, components KE-1051J-A/B (Shin-Etsu Chemical Co., Ltd.) were mixed and cured. As in Example 1, the storage elastic modulus was measured, with the results being shown by the curve of Comparative Example 1 in FIG. 3. The cured product of Comparative Example 1 had a penetration of 60. As in Example 1, a solar cell module was fabricated using the silicone gel composition. After 200 cycles of the thermal cycling test, many breaks of finger electrodes were found, with the results shown in Table 1.

### Comparative Example 2

As a silicone resin composition, components KER-2300/CAT-ME (Shin-Etsu Chemical Co., Ltd.) were mixed in a ratio of 100/3 and cured. As in Example 1, the storage elastic modulus was measured, with the results being shown by the curve of Comparative Example 2 in FIG. 3. The cured product of Comparative Example 2 had a Durometer Type D hardness of 50. As in Example 1, a solar cell module was fabricated using the silicone resin composition. After 200 cycles of the thermal cycling test, cell cracks and separation at the glass/encapsulant interface were detected, with the results shown in Table 1.

**Table 1**

| | Reference Example | Example | | | Comparative Example | |
|---|---|---|---|---|---|---|
| | | 1 | 2 | 3 | 1 | 2 |
| Breaks of finger electrodes | detected | nil | nil | nil | detected | nil |
| Cell cracks | nil | nil | nil | nil | nil | detected |
| Separation at glass/ encapsulant interface | - | nil | nil | nil | nil | detected |

It has been demonstrated that a silicone encapsulant layer having a storage elastic modulus of 1 to 300 MPa in a temperature range of -40°C to 85°C is effective for suppressing thermal expansion/contraction of the module interior with temperature changes. The resulting solar cell module is reliable in that thermal loads cause no substantial break to finger electrodes on solar cells.

## Claims

1. A silicone encapsulant composition comprising
(A) 100 parts by weight of an organopolysiloxane represented by the average compositional formula (I):
R¹ₐSiO_{(4-a)/2} (I)
wherein R¹ is each independently a substituted or unsubstituted monovalent hydrocarbon group, and a is a positive number of 1.95 to 2.05, and having a degree of polymerization of at least 100 as measured by GPC using polystyrene standards,
(B) 30 to 90 parts by weight of reinforcing silica having a BET specific surface area of at least 50 m²/g,
(C) an effective amount to cure component (A) of a curing agent, and
(D) 0 to 10 parts by weight of a tackifier, wherein the silicone encapsulant composition is for forming a silicone encapsulant layer that has a storage elastic modulus of 1 to 300 MPa measured in a temperature range of -40°C to 85°C using a viscoelasticity meter as disclosed in the description, wherein the silicone encapsulant layer is for encapsulating a solar cell matrix,
wherein the solar cell matrix comprises a plurality of solar cells interposed between light-receiving surface and back surface panels having rigidity or flexibility, wherein the panels are comprised in a solar cell module.

2. The silicone encapsulant composition of claim 1 wherein at least 0.01 part by weight of component (D) is present per 100 parts by weight of component (A), and component (D) contains at least one alkoxy, epoxy or (meth)acrylic group.

3. A method of producing a sheet having a thickness of 0.3 to 2.5 mm by shaping the silicone encapsulant composition of claim 1 or 2.

4. The method of claim 3, wherein shaping is performed by calendering or extrusion molding.

5. A method for manufacturing a solar cell module, comprising the steps of laminating a light-receiving surface panel, the encapsulant composition of claim 1 or 2, a solar cell matrix, the encapsulant composition of claim 1 or 2, and a back surface panel in order, and heating and compressing the laminate in vacuum using a vacuum laminator.

6. A solar cell module comprising a light-receiving surface panel, a cured product of the encapsulant composition of claim 1 or 2, a solar cell matrix, a cured product of the encapsulant composition of claim 1 or 2, and a back surface panel in order.

## Patentansprüche

1. Silicon-Einkapselungszusammensetzung, umfassend
(A) 100 Gewichtsteile eines Organopolysiloxans, wiedergegeben durch die durchschnittliche Zusammensetzungformel (I):
R¹ₐSiO_{(4-a)/2} (I)
worin R¹ jeweils unabhängig eine substituierte oder unsubstituierte, einwertige Kohlenwasserstoffgruppe ist, und a eine positive Zahl von 1,95 bis 2,05 ist, und mit einem Polymerisationsgrad von mindestens 100, gemessen durch GPC unter Verwendung von Polystyrolstandards,
(B) 30 bis 90 Gewichtsteile eines Verstärkungssilica mit einer spezifischen Oberfläche nach BET von mindestens 50 m²/g
(C) eine wirksame Menge eines Härtungsmittels, um Komponente (A) zu härten, und
(D) 0 bis 10 Gewichtsteile eines Klebrigmachers, wobei die Silicon-Einkapselungszusammensetzung zur Bildung einer Silicon-Einkapselungsschicht dient, welche einen Speicherelastizitätsmodul von 1 bis 3 MPa besitzt, gemessen in einem Temperaturbereich von -40 °C bis 85 °C unter Verwendung eines Viskoelastizitätsmeters, wie in der Beschreibung offenbart, wobei die Silicon-Einkapselungsschicht zur Einkapselung einer Solarzellenmatrix dient, wobei die Solarzellenmatrix eine Vielzahl von Solarzellen umfasst, die zwischen Lichtaufnahmeoberflächen- und Rückseitenpaneelen mit Steifigkeit oder Flexibilität angeordnet sind, wobei die Paneelen in einem Solarzellenmodul beinhaltet sind.

2. Silicon-Einkapselungszusammensetzung nach Anspruch 1, wobei mindestens 0,01 Gewichtsteile an Komponente (D) pro 100 Gewichtsteilen an Komponente (A) vorhanden sind, und Komponente (D) mindestens eine Alkoxy-, Epoxy- oder (Meth)acrylgruppe enthält.

3. Verfahren zur Herstellung einer Folie mit einer Dicke von 0,3 bis 2,5 mm durch Formen der Silicon-Einkapselungszusammensetzung nach Anspruch 1 oder 2.

4. Verfahren nach Anspruch 3, wobei das Formen durchgeführt wird durch Kalandrieren oder Strangpressen.

5. Verfahren zur Herstellung eines Solarzellenmoduls, umfassend die Schritte des Laminierens einer Lichtaufnahmeoberflächenpaneele, der Einkapselungszusammensetzung nach Anspruch 1 oder 2, einer Solarzellenmatrix, der Einkapselungszusammensetzung nach Anspruch 1 oder 2, und einer Rückseitenpaneele in dieser Reihenfolge, und des Erhitzens und Verpressens des Laminats im Vakuum unter Verwendung eines Vakuumlaminators.

6. Solarzellenmodul, umfassend eine Lichtaufnahmeoberflächenpaneele, ein gehärtetes Produkt aus der Einkapselungszusammensetzung nach Anspruch 1 oder 2, eine Solarzellenmatrix, ein gehärtetes Produkt aus der Einkapselungszusammensetzung nach Anspruch 1 oder 2, und eine Rückseitenpaneele in dieser Reihenfolge.

## Revendications

1. Une composition d'encapsulation de silicone comprenant
(A) 100 parties en poids d'un organopolysiloxane représenté par la formule de composition moyenne (I):
R¹ₐSiO_{(4-a)/2} (I)
dans laquelle R¹ est chacun indépendamment un groupe hydrocarboné monovalent substitué ou non substitué, et a est un nombre positif de 1,95 à 2,05, et ayant un degré de polymérisation d'au moins 100, tel que mesurée par GPC en utilisant des standards de polystyrène,
(B) 30 à 90 parties en poids de silice renforçante ayant une surface spécifique BET d'au moins 50 m²/g,
(C) une quantité efficace pour durcir le composant (A) d'un agent de durcissement, et
(D) 0 à 10 parties en poids d'un agent d'adhésivité, dans laquelle la composition d'encapsulation à base de silicone est destinée pour la formation d'une couche d'encapsulation de silicone qui a un module d'élasticité de stockage de 1 à 300 MPa mesuré dans une plage de températures de -40° C à 85° C en utilisant un appareil de mesure de viscoélasticité tel que décrit dans la description,
dans laquelle la couche d'encapsulation et pour l'encapsulation d'une matrice de cellules solaires,
dans laquelle la matrice de cellules solaires comprend 1 pluralité de cellules solaires interposées entre un panneau de surface recevant la lumière est un panneau de surface arrière ayant une rigidité ou une flexibilité, dans laquelle les panneaux sont compris dans un module de cellules solaires.

2. La composition d'encapsulation de silicone selon la revendication 1, dans laquelle au moins 0,01 partie en poids de composant (D) est présent pour 100 parties en poids de composant (A), et le composant (D) contient au moins un groupe alcoxy, époxy ou (méth)acrylique.

3. Un procédé de fabrication d'une feuille ayant une épaisseur de 0,3 à 2,5 mm par façonnement d'une composition d'encapsulation de silicone selon l'une quelconque des revendications 1 ou 2.

4. Le procédé selon la revendication 3, dans lequel le façonnement est effectué par calandrage ou moulage par extrusion.

5. Un procédé pour la fabrication d'un module de cellules solaires,
comprenant les étapes consistant en la stratification d'un panneau de surface recevant la lumière, de la composition d'encapsulation selon la revendication 1 ou 2, d'une matrice de cellules solaires, de la composition d'encapsulation selon la revendication 1 ou 2, et d'un panneau de surface arrière dans l'ordre, et le chauffage et la compression du stratifié dans un vide en utilisant un appareil de stratification sous vide.

6. Un module de cellules solaires comprenant un panneau de surface recevant la lumière, un produit durci de la composition d'encapsulation selon la revendication 1 ou 2, une matrice de cellules solaires, un produit durci de la composition d'encapsulation selon la revendication 1 ou 2, et un panneau de surface arrière dans l'ordre.
